(19) Europäisches Patentamt / European Patent Office / Office européen des brevets

(11) **EP 4 451 383 A1**

(12) **EUROPEAN PATENT APPLICATION**
published in accordance with Art. 153(4) EPC

(43) Date of publication:
**23.10.2024   Bulletin 2024/43**

(21) Application number: **22950536.7**

(22) Date of filing: **12.07.2022**

(51) International Patent Classification (IPC):
$H01M\ 4/38^{(2006.01)}$        $H01M\ 4/62^{(2006.01)}$

(52) Cooperative Patent Classification (CPC):
**H01M 4/38; H01M 4/62;** Y02E 60/10

(86) International application number:
**PCT/CN2022/105168**

(87) International publication number:
**WO 2024/011405 (18.01.2024 Gazette 2024/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Contemporary Amperex Technology (Hong Kong) Limited**
**Central, Central And Western District (HK)**

(72) Inventors:
• **WU, Kai**
  **Ningde, Fujian 352100 (CN)**

• **DONG, Xiaobin**
  **Ningde, Fujian 352100 (CN)**
• **LI, Yuan**
  **Ningde, Fujian 352100 (CN)**
• **LV, Zijian**
  **Ningde, Fujian 352100 (CN)**
• **LIU, Liangbin**
  **Ningde, Fujian 352100 (CN)**
• **WANG, Jiazheng**
  **Ningde, Fujian 352100 (CN)**

(74) Representative: **Kraus & Lederer PartGmbB**
**Thomas-Wimmer-Ring 15**
**80539 München (DE)**

(54) **SILICON-CARBON COMPOSITE MATERIAL AND NEGATIVE ELECTRODE SHEET CONTAINING SAME**

(57)    The present application relates to a silicon-carbon composite material in the form of particles comprising a porous carbon skeleton, a silicon-containing deposition layer, and a carbon-containing coating layer, wherein the silicon-containing deposition layer is in pores of the porous carbon skeleton, the carbon-containing coating layer is on the silicon-containing deposition layer and/or on the surface of the particles, and the silicon-carbon composite material has an oil absorption number of 35 mL/100 g to 80 mL/100 g. The silicon-carbon composite material of the present application has a high energy density and an improved cycle life. In addition, the present application further relates to a negative electrode plate comprising the material, a secondary battery, a battery module, a battery pack, and a power consuming device.

*FIG. 1*

EP 4 451 383 A1

## Description

### Technical Field

The present application relates to the technical field of lithium batteries, and in particular to a silicon-carbon composite material. The present application further relates to a negative electrode plate comprising the silicon-carbon composite material, a secondary battery, a battery module, a battery pack, and a power consuming device.

### Background Art

As the lithium-ion secondary batteries are widely used in the field of energy storage, high attention has been paid to the energy density and long-term performance thereof in the art, and a lot of work has been done in this regard, including material improvement. A silicon-carbon composite material is highly favored due to the characteristic of a high energy density, etc. However, since a silicon-based material has a high interfacial activity, it easily causes side reactions after being contact with an electrolyte, which affects the interface stability of the electrode plate. Therefore, after multiple cycles, the capacity of the material is prone to decay, shortening the service life of the material and battery.

Therefore, there is an urgent demand for materials with a high energy density and a long cycle life in this field.

### Summary of the Invention

In view of the above problems, the present application has been made with an object to provide a silicon-carbon composite material, and a negative electrode plate comprising the material. The silicon-carbon composite material of the present application has a less side reaction tendency, a long cycle life, and enables a secondary battery to have a good energy density and cycle life.

A first aspect of the present application provides a silicon-carbon composite material, in the form of particles comprising a porous carbon skeleton, a silicon-containing deposition layer, and a carbon-containing coating layer, wherein the silicon-containing deposition layer is in pores of the porous carbon skeleton, the carbon-containing coating layer is on the silicon-containing deposition layer and/or on the surface of the particles, and the silicon-carbon composite material has an oil absorption number of 35 mL/100 g to 80 mL/100 g. The silicon-carbon composite material of the present application can enable a secondary battery to have a good energy density and cycle life.

In any embodiment, the silicon-carbon composite material has an oil absorption number of 45 mL/100 g to 70 mL/100 g, optionally 48 mL/100 g to 62 mL/100 g. Controlling the oil absorption number of the material in the above ranges can further improve the energy density and cycle life.

In any embodiment, the silicon content at the center of the particles of the silicon-carbon composite material is ≥ 10 wt%, optionally ≥ 15 wt%, more optionally 20 wt% to 35 wt%, based on the total weight of the particles; wherein the silicon content at the center of the particles is obtained by the following methods: among the cross-sections of the particles that are obtained by subjecting the material to ion polishing, selecting a cross-section with a long axis length equal to the volume-average particle size of the particles, and determining the silicon content at the midpoint of the long axis on the selected cross-section. The silicon-carbon composite material of the present application is less prone to react with the electrolyte, thereby improving the cycle life.

In any embodiment, the porous carbon skeleton has a connected-pore structure and has an oil absorption number of ≥ 100 mL/100 g, optionally ≥ 120 mL/100 g, more optionally ≥ 150 mL/100 g and ≤ 190 mL/100 g; and optionally, the porous carbon skeleton has an oil absorption number of 136 mL/100 g to 179 mL/100 g. Such a porous carbon skeleton facilitates the distribution of a silicon deposition layer inside the material particles, which is helpful in improving the energy density and cycle life.

In any embodiment, the silicon-carbon composite material comprises 20 wt% to 60 wt%, optionally 30 wt% to 50 wt%, more optionally 35 wt% to 45 wt% of silicon, based on the total weight of the silicon-carbon composite material. In this way, the material is enabled to have a good energy density and cycling performance.

In any embodiment, the carbon-containing coating layer accounts for 3 wt% to 10 wt%, optionally 3.5 wt% to 7 wt%, more optionally 4 wt% to 6 wt%, based on the total weight of the silicon-carbon composite material. Controlling the content of the carbon coating layer can further improve the cycle life.

In any embodiment, the oil absorption number X1 of the porous carbon skeleton, the oil absorption number X2 of the silicon-carbon composite material, the weight percentage Y1 of silicon in the silicon-carbon composite material, and the weight percentage Y2 of the carbon coating layer satisfy: $k = \dfrac{X1}{Y1 \times Y2 \times X2}$, and

k is any value of 100 to 250, optionally 130 to 180. Such silicon-carbon composite material has both a good energy density and a longer cycle life.

A second aspect of the present application further provides a silicon-carbon composite material, which is prepared by the following steps:

i) providing a porous carbon skeleton, wherein the porous carbon skeleton has a connected-pore structure and has an oil absorption number of ≥ 100 mL/100 g and ≤ 190 mL/100 g;

ii) forming a silicon-containing deposition layer in pores of the porous carbon skeleton by means of chemical vapor deposition using a silicon-containing gas source to obtain an intermediate material; and

iii) forming a carbon-containing coating layer on the silicon-containing deposition layer of the intermediate material and/or on the surface of the particles of the porous carbon skeleton to obtain the granular silicon-carbon composite material, wherein the carbon-containing coating layer accounts for 3 wt% to 10 wt%, based on the total weight of the silicon-carbon composite material; and wherein the silicon-carbon composite material has an oil absorption number of 35 mL/100 g to 80 mL/100 g. Such silicon-carbon composite material enables a secondary battery to have a good energy density and cycle life.

In any embodiment, the silicon-carbon composite material has an oil absorption number of 45 mL/100 g to 70 mL/100 g, optionally 48 mL/100 g to 62 mL/100 g. Controlling the oil absorption number of the material in the above ranges can further improve the energy density and cycle life.

In any embodiment, the silicon content at the center of the particles of the silicon-carbon composite material is ≥ 10 wt%, optionally ≥ 15 wt%, more optionally 20 wt% to 35 wt%, based on the total weight of the particles; wherein the silicon content at the center of the particles is obtained by the following methods: among the cross-sections of the particles that are obtained by subjecting the material to ion polishing, selecting a cross-section with a long axis length equal to the volume-average particle size of the particles, and determining the silicon content at the midpoint of the long axis on the selected cross-section. In this way, the cycle life can be further improved.

In any embodiment, the porous carbon skeleton has an oil absorption number of ≥ 120 mL/100 g, optionally ≥ 150 mL/100 g; and optionally, the porous carbon skeleton has an oil absorption number of 136 mL/100 g to 179 mL/100 g. In this way, it is helpful in further improving the energy density and the cycle life.

In any embodiment, the silicon-carbon composite material comprises 20 wt% to 60 wt%, optionally 30 wt% to 50 wt%, more optionally 35 wt% to 45 wt% of silicon, based on the total weight of the silicon-carbon composite material. In this way, the material is enabled to have a good capacity per gram and cycling performance.

In any embodiment, the carbon-containing coating layer accounts for 3.5 wt% to 7 wt% more optionally 4 wt% to 6 wt%, based on the total weight of the silicon-carbon composite material. Controlling the content of the carbon coating layer can further improve the cycle life.

In any embodiment, the oil absorption number X1 of the porous carbon skeleton, the oil absorption number X2 of the silicon-carbon composite material, the weight percentage Y1 of silicon in the silicon-carbon composite material, and the weight percentage Y2 of the carbon coating layer satisfy the following relationship:

$$k = \frac{X1}{Y1 \times Y2 \times X2},$$

and

k is any value of 100 to 250, optionally 130 to 180. Such silicon-carbon composite material has both a good energy density and a longer cycle life.

A third aspect of the present application further provides a negative electrode plate, comprising a current collector and a negative electrode material layer provided on at least one surface of the current collector, wherein the negative electrode material layer comprises a silicon-carbon composite material of the present application. The negative electrode plate of the present application has a good energy density and cycling performance.

In any embodiment, the negative electrode material layer comprises 5 wt% to 50 wt%, optionally 10 wt% to 30 wt%, more optionally 15 wt% to 25 wt% of the silicon-carbon composite material, based on the total weight of the negative electrode material layer. In this way, the performance of the electrode plate can be further improved.

A fourth aspect of the present application provides a secondary battery, comprising a silicon-carbon composite material of the first and second aspects of the present application or a negative electrode plate of the third aspect of the present application.

A fifth aspect of the present application provides a battery module comprising a secondary battery of the fourth aspect of the present application.

A sixth aspect of the present application provides a battery pack comprising a battery module of the fifth aspect of the present application.

A seventh aspect of the present application provides a power consuming device, comprising at least one selected from a secondary battery of the fourth aspect of the present application, a battery module of the fifth aspect of the present application, or a battery pack of the sixth aspect of the present application.

The silicon-carbon composite material of the present application has a higher energy density and a significantly improved cycle life.

**Brief Description of the Drawings**

Fig. 1 shows an ion-polished cross-sectional topographic analysis image of a silicon-carbon composite material particles according to an embodiment of the present invention.
Fig. 2 shows a schematic diagram of a secondary battery according to an embodiment of the present application.
Fig. 3 shows an exploded view of the secondary battery according to an embodiment of the present application as shown in Fig. 2.
Fig. 4 shows a schematic diagram of a battery module according to an embodiment of the present application.
Fig. 5 shows a schematic diagram of a battery pack according to an embodiment of the present application.
Fig. 6 shows an exploded view of the battery pack according to an embodiment of the present application as shown in Fig. 5.
Fig. 7 shows a schematic diagram of a power consuming device using a secondary battery according to an embodiment of the present application as a power source.

List of reference numerals: 1 - battery pack; 2 - upper box body; 3 - lower box body; 4 - battery module; 5 - secondary battery; 51 - housing; 52 - electrode assembly; 53 - top cover assembly

**Detailed Description of Embodiments**

Hereinafter, embodiments of the silicon-carbon composite material particles and the preparation method therefor, the negative electrode plate, the secondary battery, the battery module, the battery pack, and the electrical device of the present application are described in detail and specifically disclosed with reference to the accompanying drawings as appropriate. However, unnecessary detailed illustrations may be omitted in some instances. For example, there are situations where detailed description of well known items and repeated description of actually identical structures are omitted. This is to prevent the following description from being unnecessarily verbose, and facilitates understanding by those skilled in the art. Moreover, the accompanying drawings and the descriptions below are provided for enabling those skilled in the art to fully understand the present application, rather than limiting the subject matter disclosed in claims.

The "ranges" disclosed in the present application are defined in the form of lower and upper limits. A given range is defined by selecting a lower limit and an upper limit, and the selected lower and upper limits defining the boundaries of the particular range. Ranges defined in this manner may be inclusive or exclusive, and may be arbitrarily combined, that is, any lower limit may be combined with any upper limit to form a range. For example, if the ranges 60-120 and 80-110 are listed for a particular parameter, it should be understood that the ranges 60-110 and 80-120 are also contemplated. Additionally, if minimum range values 1 and 2 are listed and maximum range values 3, 4, and 5 are listed, the following ranges are all contemplated: 1-3, 1-4, 1-5, 2-3, 2-4, and 2-5. In the present application, unless stated otherwise, the numerical range "a-b" denotes an abbreviated representation of any combination of real numbers between a and b, where both a and b are real numbers. For example, the numerical range "0-5" means that all the real numbers between "0-5" have been listed herein, and "0-5" is just an abbreviated representation of combinations of these numerical values. In addition, when a parameter is expressed as an integer $\geq 2$, it is equivalent to disclosing that the parameter is, for example, an integer of 2, 3, 4, 5, 6, 7, 8, 9, 10, 11, 12, etc.

All the embodiments and optional embodiments of the present application can be combined with one another to form new technical solutions, unless otherwise stated.

All technical features and optional technical features of the present application can be combined with one another to form a new technical solution, unless otherwise stated.

Unless otherwise stated, all the steps of the present application may be performed sequentially or randomly, preferably sequentially. For example, the method including steps (a) and (b) indicates that the method may include steps (a) and (b) performed sequentially, and may also include steps (b) and (a) performed sequentially. For example, reference to "the method may further include step (c)" indicates that step (c) may be added to the method in any order, e.g., the method may include steps (a), (b) and (c), or steps (a), (c) and (b), or steps (c), (a) and (b), etc.

The terms "comprise" and "include" mentioned in the present application are open-ended or may also be closed-ended, unless otherwise stated. For example, "comprise" and "include" may mean that other components not listed may further be comprised or included, or only the listed components may be comprised or included.

In the present application, the term "or" is inclusive unless otherwise specified. For example, the phrase "A or B" means "A, B, or both A and B". More specifically, the condition "A or B" is satisfied by any one of the following: A is true (or present) and B is false (or not present); A is false (or not present) and B is true (or present); or both A and B are true (or present).

As the lithium-ion secondary batteries are widely used in the field of energy storage, high attention has been paid to the energy density and long-term performance thereof in the art, and a lot of work has been done in this regard, including material improvement. A silicon-carbon composite material is highly favored due to the characteristic of a high energy density, etc. However, a silicon-based material has a high interfacial activity and easily causes side reactions after being contact with an electrolyte solution, which affects the interface stability of the electrode plate. As a result, after multiple cycles, the capacity of the material is prone to decay, thus shortening the service life of the material and battery.

Therefore, there is an urgent demand for a negative electrode active material with a high energy density and long cycle life in this field. The present invention satisfies such demands and provides related advantages.

**Silicon-carbon composite material**

In one embodiment of the present application, proposed is a silicon-carbon composite material, in the form of particles comprising a porous carbon skeleton, a silicon-containing deposition layer, and a carbon-containing coating layer, wherein the silicon-containing deposition layer is in pores of the porous carbon skeleton, the carbon-containing coating layer is on the silicon-containing deposition layer and/or on the surface of the particles, and the silicon-carbon composite material has an oil absorption number of 35 mL/100 g to 80 mL/100 g.

The silicon-carbon composite material of the present application can improve the energy density (e.g., capacity per gram) and cycle life of a lithium-ion secondary battery. Without wishing to be bound by any theory, the reason may be that the silicon-carbon composite material of the present application, in particular those having a carbon coating layer and an oil absorption number in the above ranges, can effectively reduce the electrolyte entering and coming into contact with a silicon-containing deposition layer in pores of the material to cause side reactions, thus significantly improving the cycle life of a lithium-ion secondary battery. Herein, the term "oil absorption number" denotes the number (mL) of volume of an organic solvent (e.g., dibutyl phthalate, acrylates) absorbed by 100 g of the silicon-carbon composite material. The oil absorption number can be determined with reference to the method described in GB/T 3780.2-2007. The oil absorption number of a porous material can reflect the unobstruction of the pores of a material. A larger oil absorption number of a material indicates that the pores of the material are more unobstructed, and a liquid (e.g., an electrolyte) or a gas (e.g., various source gases, such as a silane gas for silicon deposition) is easier to pass through the pores and reach deep inside the material.

In some embodiments, the silicon-carbon composite material has an oil absorption number of 45 mL/100 g to 70 mL/100 g, optionally 48 mL/100 g to 62 mL/100 g. Controlling the oil absorption number of the material in the above ranges can further improve the cycle life of a lithium-ion secondary battery.

In some embodiments, the silicon content at the center of the particles of the silicon-carbon composite material of the silicon-carbon composite material is $\geq$ 10 wt%, optionally $\geq$ 15 wt%, more optionally 20 wt% to 35 wt%, based on the total weight of the particle; wherein the silicon content at the center of the particles is obtained by the following methods: among the cross-sections of the particles that are obtained by subjecting the material to ion polishing, selecting a cross-section with a long axis length equal to the volume-average particle size of the particles, and determining the silicon content at the midpoint of the long axis on the selected cross-section.

Herein, the silicon content at the center of the particles indicates the content of silicon at the central area (that is, the area, for example from the particle surface) inside the material particles. In the case where the total silicon content is comparable, the material of the present application has a higher silicon content at the center of the material particles when compared with the silicon-carbon composite materials in the prior art. Therefore, compared with the similar materials having a silicon deposition layer mainly existing in a superficial layer in the prior art, the silicon-carbon composite material of the present application is less prone to react with an electrolyte, which is beneficial for improving the cycle life.

In some embodiments, the value of the silicon content at the center of the particles may be an average value of the silicon content at the midpoint of the long axis on a plurality of selected cross-sections.

Herein, the "long axis" means the straight line connecting the two points farthest apart on the cross-section of the particles. In the case of a circular cross-section, the long axis is the diameter.

Herein, "volume-average particle size (Dv50)" has a meaning well-known in the art and may be measured by means of an instrument and method known in the art. For example, the Dv50 can be determined with reference to GB/T 19077-2016 particle size distribution-laser diffraction method, using a laser particle size analyzer.

Herein, unless otherwise specified, "wt%", "wt.%", "%", or other similar expressions have the same meaning and all represent a weight percentage.

The silicon content at any point of the material particles can be determined by a suitable method known in the art, for example, X-ray energy dispersive spectrum (EDS).

In some embodiments, the porous carbon skeleton has a connected-pore structure and has an oil absorption number of $\geq$ 100 mL/100 g, optionally $\geq$ 120 mL/100 g, more optionally $\geq$ 150 mL/100 g and $\leq$ 190 mL/100 g. In some embodiments, optionally, the porous carbon skeleton has an oil absorption number of $\leq$ 185 mL/100 g, more optionally $\leq$ 180 mL/100 g. In some embodiments, optionally, the porous carbon skeleton has an oil absorption number of 136 mL/100 g to 179 mL/100 g. The porous carbon skeleton having an oil absorption number in the above ranges enables the particles to have a highly unobstructed pore, which is beneficial for silicon to enter inside the particles for deposition. In the present application, the silicon-containing deposition layer in the silicon-carbon composite material may be advantageously distributed throughout the bulk phase of the porous carbon skeleton material particles; and advantageously, a silicon precursor reaches and deposits at the central area of the porous carbon skeleton particles more easily. Compared with the case where a large amount of silicon is deposited on the surface of the particles in the prior art, the silicon-carbon composite material of the present application is less prone to swell to cause the pulverization of the particles during the charging process, which is beneficial for improving the cycle life of a battery.

It should be understood by a person skilled in the art that although it is desired in the present application that the oil absorption number of the porous carbon skeleton should be as large as possible, the porous carbon skeleton may have an oil absorption number of not more than 190 mL/100 g when factors such as the structural stability of the porous carbon skeleton itself are taken into consideration.

Herein, the term "connected-pore structure" means that the pores in the material particles are in communication with each other and form a continuous network structure inside the material particles.

In some embodiments, the porous carbon skeleton has a total pore volume of $\geq$ 1 cm$^3$/g. In some embodiments, the porous carbon skeleton has a macropore volume of $\leq$ 0.2 cm$^3$/g, a mesopore volume of $\geq$ 0.5 cm$^3$/g, and a micropore volume of $\leq$ 0.3 cm$^3$/g. In some embodiments, the porous carbon skeleton has a specific surface area (BET) of 700 m$^2$/g to 1500 m$^2$/g. Such a pore content is more beneficial for the deposition of a silicon-containing deposition layer at the central area of the carbon skeleton, enabling a high silicon content at the center of the particles, thus improving the energy density and cycling performance of the material and a battery. Particularly, the porous carbon skeleton has more mesopore structures, which is beneficial for the uniform distribution of a silicon deposition layer therein, provides the silicon material with sufficient spaces for volume change during the cycling process, and thus is beneficial for improving the cycle life.

In the present application, the porous carbon skeleton can be obtained by using, for example, an agricultural by-product (e.g., coconut husks, rice husks, straw, corn cobs, etc.), a synthetic polymer (e.g., phenolic resins, epoxy resins), or a natural polymer (e.g., starch, cellulose, lignin) as a raw material by means of a well-known method in the art (e.g., carbonization).

In some embodiments, the silicon-carbon composite material comprises 20 wt% to 60 wt%, optionally 30 wt% to 50 wt%, more optionally 35 wt% to 45 wt%, more optionally 40 wt% of silicon, based on the total weight of the silicon-carbon composite material. The silicon-carbon composite material of the present application comprising a silicon content mentioned above not only can ensure the capacity per gram of the material but also may be beneficial for maintaining the structural stability of the material (for example, after the lithium-intercalation charging process, the volume expansion of silicon will not destroy the structure of the carbon skeleton to cause pulverization), thus allowing a good cycling performance.

In some embodiments, the carbon-containing coating layer accounts for 3 wt% to 10 wt%, optionally 3.5 wt% to 7 wt%, more optionally 4 wt% to 6 wt%, more optionally 5 wt% of the total weight of the silicon-carbon composite material. The silicon-carbon composite material of the present application having a carbon coating layer at a content in the above ranges is beneficial for controlling the oil absorption number within an ideal range, reduces the exposure of pores with silicon deposited in the material and reduces the irreversible consumption caused by the reaction between the silicon-containing deposition layer with an electrolyte, thus improving the cycling performance of the material. Without wishing to be bound by any theory, the carbon coating reduces the volume of the silicon-carbon composite material in which an electrolyte can enter and reduces the exposure of the silicon-containing deposition layer to the electrolyte, thus effectively reducing the contact of the electrolyte with the silicon material in the pores and improving the cycle life.

In some embodiments, in the silicon-carbon composite material of the present application, the oil absorption number X1 of the porous carbon skeleton, the oil absorption number X2 of the silicon-carbon composite material, the weight percentage Y1 of silicon in the silicon-carbon composite material, and the weight percentage Y2 of the carbon coating layer satisfy:

$$k = \frac{X1}{Y1 \times Y2 \times X2},$$

and

k is any value of 100 to 250, optionally 130 to 180.

Such silicon-carbon composite material has both a good energy density (e.g., capacity per gram) and a longer cycle life.

In some embodiments, the particles of the silicon-carbon composite material have a total pore volume of $\leq 0.6$ cm$^3$/g as determined by means of nitrogen adsorption. In some embodiments, the particle of the silicon-carbon composite material comprises $\leq 0.1$ cm$^3$/g of micropores, $\leq 0.3$ cm$^3$/g of mesopores, and $\leq 0.1$ cm$^3$/g of macropores. The silicon-carbon composite material of the present application has a relatively high content of mesopore structure with a silicon-containing deposition layer uniformly distributed therein, and such a structure allows silicon to be sealed in the pores of the carbon skeleton by carbon coating. A relatively high content of mesopores provide expansion spaces for silicon and the carbon coating prevents an electrolyte solution from entering into pores and coming into contact with silicon to cause side reactions, and thus the cycle life is improved.

Herein, the "micropore" generally refers to a pore having a pore diameter less than about 2 nanometers; the "mesopore" generally refers to a pore having a pore diameter of about 2 nanometers to about 50 nanometers in diameter; and the "macropore" generally refers to a pore having a pore diameter greater than 50 nanometers.

In some embodiments, the particles of the silicon-carbon composite material have a specific surface area of 1 m$^2$/g to 15 m$^2$/g, optionally 4 m$^2$/g to 10 m$^2$/g, more optionally 6.5 m$^2$/g to 7.5 m$^2$/g, more optionally 7 m$^2$/g. In some embodiments, the particles of the silicon-carbon composite material have a volume-average particle size Dv50 of 5 μm to 15 μm, optionally 8 μm to 12 μm. In some embodiments, the Dv50 of the silicon-carbon composite material is more optionally 9.5 μm to 10.5 μm. In some embodiments, optionally, the Dv50 of the silicon-carbon composite material is 10 μm.

In another embodiment of the present application, proposed is a silicon-carbon composite material, which is prepared by the following steps:

    i) providing a porous carbon skeleton having a connected-pore structure, wherein the porous carbon skeleton has a connected-pore structure and has an oil absorption number of $\geq 100$ mL/100 g and $\leq 190$ mL/100 g;
    ii) forming a silicon-containing deposition layer in pores of the porous carbon skeleton by means of chemical vapor deposition to obtain an intermediate material; and
    iii) forming a carbon-containing coating layer on the silicon-containing deposition layer of the intermediate material and/or on the surface of the particles of the porous carbon skeleton to obtain the silicon-carbon composite material, wherein the carbon-containing coating layer accounts for 3 wt% to 10 wt%, based on the total weight of the silicon-carbon composite material; and

wherein the silicon-carbon composite material has an oil absorption number of 35 mL/100 g to 80 mL/100 g. The silicon-carbon composite material of the present application can enable a secondary battery to have a good cycle life.

Without wishing to be bound by any theory, in the present application, the advantage of using a porous carbon skeleton with a higher oil absorption number as a raw material lies in the higher unobstruction of the pores. Therefore, compared with similar materials that do not have such an oil absorption number in the prior art, the carbon skeleton with a high oil absorption number of the present application is conducive to uniformly and penetratively deposit silicon to the depth of a pore in the carbon skeleton, even to the particle center, by means of vapor deposition. Carbon coating is then carried out on the surface of the particle to seal the silicon deposition layer in the pores and thus the oil absorption number of the final material is significantly reduced, so as to obtain a silicon-carbon composite material having a low oil absorption number. The silicon-carbon composite material is obtained in such a way that the material has a carbon skeleton characterized by providing spaces for potential volume changes of the silicon-containing deposition layer during cycling, without a substantial effect on the structural stability of the material; and moreover, the carbon coating layer and final material having a small oil absorption number (that is, a low pore unobstruction) effectively prevent a large amount of electrolyte from entering into the pores (in particular inside the particle) and interreacting with the silicon-containing deposition layer to cause side reactions. In summary, due to the structural features of its raw material, i.e., the carbon skeleton, and the final material themselves, the silicon-carbon composite material of the present application can alleviate (or avoid) the structural instability caused by the expansion of silicon inside the material and simultaneously reduce the side reactions due to the contact between an electrolyte and the silicon material. Therefore, the material of the present application has an improved cycle life.

Herein, the "chemical vapor deposition (CVD)" refers to forming a non-volatile coating by a chemical reaction occurring on the heated surface of a matrix (e.g., a porous carbon skeleton) using a gaseous compound or a mixture thereof.

In some embodiments, the silicon-carbon composite material has an oil absorption number of 45 mL/100 g to 70 mL/100 g, optionally 48 mL/100 g to 62 mL/100 g. Controlling the oil absorption number of the material in the above ranges can further improve the cycle life of a lithium-ion secondary battery.

In some embodiments, the silicon content at the center of the particles of the silicon-carbon composite material is $\geq 10$ wt%, optionally $\geq 15$ wt%, more optionally 20 wt% to 35 wt%, based on the total weight of the particle; wherein the silicon content at the center of the particles is obtained by the following methods: among the cross-sections of the particles that are obtained by subjecting the material to ion polishing, selecting a cross-section with a long axis length equal to the volume-average particle size of the particles, and determining the silicon content at the midpoint of the long axis on the selected cross-section. The silicon-carbon composite material of the present application has a high silicon content inside the particles thereof and therefore is less prone to react with an electrolyte, thereby improving the cycle life.

In some embodiments, the porous carbon skeleton has an oil absorption number of $\geq$ 120 mL/100 g, optionally $\geq$ 150 mL/100 g; and optionally, the porous carbon skeleton has an oil absorption number of 136 mL/100 g to 179 mL/100 g. Such a porous carbon skeleton facilitates the distribution of a silicon deposition layer inside the material particles, which is helpful in improving the energy density and cycle life.

In some embodiments, the silicon-carbon composite material comprises 20 wt% to 60 wt%, optionally 30 wt% to 50 wt%, more optionally 35 wt% to 45 wt% of silicon. In this way, the material is enabled to have a good energy density and cycling performance.

In some embodiments, the carbon-containing coating layer accounts for 3.5 wt% to 7 wt%, optionally 4 wt% to 6 wt%, based on the total weight of the silicon-carbon composite material. Controlling the content of the carbon coating layer can further improve the cycle life.

In some embodiments, in the silicon-carbon composite material, the oil absorption number X1 of the porous carbon skeleton, the oil absorption number X2 of the silicon-carbon composite material, the weight percentage Y1 of silicon in the silicon-carbon composite material, and the weight percentage Y2 of the carbon coating layer satisfy the following relationship:

$$k = \frac{X1}{Y1 \times Y2 \times X2},$$

and

k is any value of 100 to 250, optionally 130 to 180. Such silicon-carbon composite material has both a good energy density and a longer cycle life.

In yet another embodiment of the present application, proposed is a method for preparing a silicon-carbon composite material, the method comprising the following steps:

i) providing a porous carbon skeleton having a connected-pore structure, wherein the porous carbon skeleton has a connected-pore structure and has an oil absorption number of $\geq$ 100 mL/100 g and $\leq$ 190 mL/100 g;

ii) forming a silicon-containing deposition layer in pores of the porous carbon skeleton by means of chemical vapor deposition to obtain an intermediate material; and

iii) forming a carbon-containing coating layer on the silicon-containing deposition layer of the intermediate material and/or on the surface of the particles of the porous carbon skeleton to obtain the silicon-carbon composite material, wherein the carbon-containing coating layer accounts for 3 wt% to 10 wt%, based on the total weight of the silicon-carbon composite material; and

wherein the silicon-carbon composite material has an oil absorption number of 35 mL/100 g to 80 mL/100 g. The method of the present application can prepare a silicon-carbon composite material having a significantly improved cycle life and a good energy density.

In some embodiments, the silicon-carbon composite material has an oil absorption number of 45 mL/100 g to 70 mL/100 g, optionally 48 mL/100 g to 62 mL/100 g.

In some embodiments, the porous carbon skeleton has an oil absorption number of $\geq$ 120 mL/100 g, optionally $\geq$ 150 mL/100 g, and $\leq$ 190 mL/100 g. In some embodiments, the porous carbon skeleton has an oil absorption number of 136 mL/100 g to 179 mL/100 g. Such a carbon skeleton is beneficial for a large amount of silicon precursor to be deposited inside (even at the central area) of the porous carbon skeleton in step ii), which allows the final material to have a good capacity per gram and improves the cycling performance of a battery.

In some embodiments, the chemical vapor deposition in step ii) is carried out in the presence of a silicon-containing gas source. In some embodiments, the silicon-containing gas source may be selected from any silicon-containing gas source commonly used for chemical vapor deposition in the art. In some embodiments, the silicon-containing gas source is selected from at least one of silane and silicon tetrachloride, optionally silane. In some embodiments, the silicon-containing gas source may also be mixed with an inert gas (e.g., nitrogen) for use. In the case of a mixed gas, the content of silane is about 5 wt% to 100 wt%, based on the total weight of the mixed gas. In some embodiments, the intake rate of the silicon-containing gas source in step ii) is 2-8 L/min, optionally 3-5 L/min, more optionally 4 L/min.

In some embodiments, the chemical vapor deposition in step ii) is carried out at a deposition temperature of 300°C to 800°C. In some embodiments, the chemical vapor deposition in step ii) is carried out for 5-15 hours, optionally 8-12 hours, optionally 10 hours.

In some embodiments, the chemical vapor deposition in step ii) is carried out under a flip-over conditions.

In some embodiments, the method of the present application further comprises a step of micro-oxidizing the surface of the intermediate material after step ii) and before step iii). The surface micro-oxidization is carried out by introducing at least one of air, carbon dioxide, carbon monoxide and water vapor into the intermediate material at a high temperature. The temperature can be determined by a person skilled in the art.

In some embodiments, the step iii) is carried out by means of coating or chemical vapor deposition.

In the case of coating, the coating means coating a layer of, for example, graphite, graphene, hard carbon, or soft carbon, on the surface of the intermediate material particles. Alternatively, a precursor material (e.g., asphalt) known in the art may be spray-coated onto the surface of the intermediate material particles to form a coating layer, followed by carbonization. In some embodiments, the amount of the added precursor material coating layer is 5-15 wt%, optionally 7-9 wt%, more optionally 8 wt%, based on the total weight of the intermediate material. The coating amount in the above ranges is beneficial for achieving a good coating effect.

In some embodiments, the precursor material is asphalt, optionally asphalt having a softening point not more than 200°C, more optionally asphalt having a softening point of 150-160°C. The asphalt having a softening point in the above ranges is more easily spread on the surface of the particles during the coating process, which is helpful in achieving a good coating effect. In the case of chemical vapor deposition, the chemical vapor deposition is carried out in the presence of a carbon-containing gas source. In some embodiments, the carbon-containing gas source may be selected from any carbon-containing gas source commonly used for chemical vapor deposition in the art. In some embodiments, the carbon-containing gas source is selected from at least one of methane, ethane, ethylene and acetylene.

The chemical vapor deposition is carried out in a reactor well-known in the art, for example, a fluidized-bed reactor, a static bed reactor, etc.

In some embodiments, the chemical vapor deposition in step iii) is carried out at a temperature of 800°C to 1200°C. In some embodiments, in the chemical vapor deposition in step iii), the intake rate of the carbon-containing gas source is 1-5 L/min, optionally 1-3 L/min, more optionally 2 L/min. In some embodiments, the chemical vapor deposition in step iii) is carried out for 1-3 hours.

## Negative electrode plate

In another embodiment of the present application, provided is a negative electrode plate, comprising a current collector and a negative electrode material layer provided on at least one surface of the current collector, wherein the negative electrode material layer comprises a silicon-carbon composite material of the present application or a silicon-carbon composite material obtained by the method of the present application.

In some embodiments, the negative electrode material layer comprises 5 wt% to 50 wt%, optionally 15 wt% to 25 wt%, more optionally 20 wt% of the silicon-carbon composite material, based on the total weight of the negative electrode material layer. The negative electrode material layer comprises a carbon-based negative electrode active material at a content in the above ranges such that a secondary battery can have both a longer cycle life and a good energy density.

In some embodiments, the negative electrode material layer further comprises 5 wt% to 50 wt% of a carbon-based negative electrode active material, based on the total weight of the negative electrode material layer. The negative electrode material layer comprises a carbon-based negative electrode active material at a content in the above ranges such that a secondary battery can have both a longer cycle life and a good energy density. As an example, the negative electrode current collector has two surfaces opposite in its own thickness direction, and the negative electrode film layer is provided on either or both of the two opposite surfaces of the negative electrode current collector.

In some embodiments, the negative electrode current collector may be a metal foil or a composite current collector. For example, as a metal foil, a copper foil can be used. The composite current collector may comprise a polymer material base layer and a metal layer formed on at least one surface of the polymer material substrate. The composite current collector can be formed by forming a metal material (copper, a copper alloy, nickel, a nickel alloy, titanium, a titanium alloy, silver and a silver alloy, etc.) on a polymer material substrate (e.g., polypropylene (PP), polyethylene terephthalate (PET), polybutylene terephthalate (PBT), polystyrene (PS), polyethylene (PE), etc.).

The present application is not limited to these materials, and other conventional materials that can be used as a negative electrode active material for batteries can also be used.

In some embodiments, the negative electrode film layer may optionally comprise a binder. The binder may be selected from at least one of a butadiene styrene rubber (SBR), polyacrylic acid (PAA), sodium polyacrylate (PAAS), polyacrylamide (PAM), polyvinyl alcohol (PVA), sodium alginate (SA), polymethacrylic acid (PMAA) and carboxymethyl chitosan (CMCS).

In some embodiments, the negative electrode film layer may optionally comprise a conductive agent. The conductive agent may be selected from at least one of superconductive carbon, acetylene black, carbon black, ketjenblack, carbon dots, carbon nanotubes, graphene, and carbon nanofibers.

In some embodiments, the negative electrode film layer may optionally comprise other auxiliary agents, such as thickener (e.g., sodium carboxymethyl cellulose (CMC-Na)), etc.

In some embodiments, the negative electrode plate can be prepared as follows: dispersing the above-mentioned components for preparing the negative electrode plate, such as negative electrode active material, conductive agent, binder and any other components, in a solvent (e.g., deionized water) to form a negative electrode slurry; and coating a negative electrode current collector with the negative electrode slurry, followed by procedures such as drying and cold pressing, so as to obtain the negative electrode plate.

**Secondary battery, battery module, battery pack and power consuming device**

In another embodiment of the present application, provided is a secondary battery, comprising a silicon-carbon composite material of the present application or a negative electrode plate of the present application. In another embodiment of the present application, provided is a battery module, comprising a secondary battery of the present application.

In another embodiment of the present application, provided is a battery pack, comprising a battery module of the present application.

In another embodiment of the present application, provided is a power consuming device, comprising at least one selected from a secondary battery, a battery module or a battery pack of the present application.

In addition, the secondary battery, battery module, battery pack and power consuming device of the present application are described below with reference to the accompanying drawings as appropriate.

In one embodiment of the present application, a secondary battery is provided.

In some embodiments, the secondary battery is a lithium-ion secondary battery.

Typically, a secondary battery comprises a positive electrode plate, a negative electrode plate, an electrolyte and a separator. During the charge/discharge of the battery, active ions are intercalated and de-intercalated back and forth between a positive electrode plate and a negative electrode plate. The electrolyte functions to conduct ions between the positive electrode plate and the negative electrode plate. The separator is provided between the positive electrode plate and the negative electrode plate, and mainly prevents the positive and negative electrodes from short-circuiting and enables ions to pass through.

[Positive electrode plate]

The positive electrode plate comprises a positive electrode current collector and a positive electrode film layer provided on at least one surface of the positive electrode current collector, the positive electrode film layer comprising the positive electrode active material of the first aspect of the present application.

As an example, the positive electrode current collector has two surfaces opposite in its own thickness direction, and the positive electrode film layer is provided on either or both of opposite surfaces of the positive electrode current collector.

In some embodiments, the positive electrode current collector may be a metal foil or a composite current collector. For example, as a metal foil, an aluminum foil can be used. The composite current collector may comprise a polymer material base layer and a metal layer formed on at least one surface of the polymer material base layer. The composite current collector can be formed by forming a metal material (aluminum, an aluminum alloy, nickel, a nickel alloy, titanium, a titanium alloy, silver and a silver alloy, etc.) on a polymer material substrate (such as polypropylene (PP), polyethylene terephthalate (PET), polybutylene terephthalate (PBT), polystyrene (PS), polyethylene (PE), etc.).

In some embodiments, the positive electrode active material can be a positive electrode active material known in the art for batteries. As an example, the positive electrode active material may comprise at least one of the following materials: lithium-containing phosphates of an olivine structure, lithium transition metal oxides, and their respective modified compounds. However, the present application is not limited to these materials, and other conventional materials that can be used as positive electrode active materials for batteries may also be used. These positive electrode active materials may be used alone or in combination of two or more. Herein, examples of lithium transition metal oxides may include, but are not limited to, at least one of lithium cobalt oxide (e.g., $LiCoO_2$), lithium nickel oxide (e.g., $LiNiO_2$), lithium manganese oxide (e.g., $LiMnO_2$, $LiMn_2O_4$), lithium nickel cobalt oxide, lithium manganese cobalt oxide, lithium nickel manganese oxide, lithium nickel cobalt manganese oxide (e.g., $LiNi_{1/3}Co_{1/3}Mn_{1/3}O_2$ (also referred to as $NCM_{333}$), $LiNi_{0.5}Co_{0.2}Mn_{0.3}O_2$ (also referred to as $NCM_{523}$), $LiNi_{0.5}Co_{0.25}Mn_{0.25}O_2$ (also referred to as $NCM_{211}$), $LiNi_{0.6}Co_{0.2}Mn_{0.2}O_2$ (also referred to as $NCM_{622}$), $LiNi_{0.8}Co_{0.1}Mn_{0.1}O_2$ (also referred to as NCMsn)), lithium nickel cobalt aluminum oxide (e.g., $LiNi_{0.85}Co_{0.15}Al_{0.05}O_2$), and modified compounds thereof, etc. Examples of lithium-containing phosphates of olivine structure may include, but are not limited to, at least one of lithium iron phosphate (e.g., $LiFePO_4$ (also referred to as LFP)), lithium iron phosphate and carbon composites, lithium manganese phosphate (e.g., $LiMnPO_4$), lithium manganese phosphate and carbon composites, lithium iron manganese phosphate, and lithium iron manganese phosphate and carbon composites.

In some embodiments, the positive electrode film layer further optionally comprises a binder. As an example, the binder may include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, and fluorine-containing acrylate resin.

In some embodiments, the positive electrode film layer also optionally comprises a conductive agent. As an example, the conductive agent may include at least one of superconducting carbon, acetylene black, carbon black, Ketjen black, carbon dots, carbon nanotubes, graphene, and carbon nanofibers.

In some embodiments, the positive electrode plate can be prepared as follows: dispersing the above-mentioned components for preparing the positive electrode plate, such as a positive electrode active material, a conductive agent, a binder and any other components, in a solvent (e.g., N-methyl pyrrolidone) to form a positive electrode slurry; and coating the positive electrode current collector with the positive electrode slurry, followed by the procedures such as drying and cold pressing, so as to obtain the positive electrode plate.

[Electrolyte]

The electrolyte functions to conduct ions between the positive electrode plate and the negative electrode plate. The type of the electrolyte is not specifically limited in the present application, and can be selected according to actual requirements. For example, the electrolyte may be in a liquid state, a gel state or an all-solid state.

In some embodiments, an electrolyte solution is used as the electrolyte. The electrolyte solution comprises an electrolyte salt and a solvent.

In some embodiments, the electrolyte salt may be selected from at least one of lithium hexafluorophosphate, lithium tetrafluoroborate, lithium perchlorate, lithium hexafluoroarsenate, lithium bisfluorosulfonimide, lithium bistrifluoromethanesulfonimide, lithium trifluoromethanesulfonate, lithium difluorophosphate, lithium difluorooxalate borate, lithium dioxalate borate, lithium difluorodioxalate phosphate and lithium tetrafluorooxalate phosphate.

In some embodiments, the solvent may be selected from at least one of ethylene carbonate, propylene carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, dimethyl sulfone, ethyl methyl sulfone, and diethyl sulfone.

In some embodiments, the electrolyte solution may optionally include an additive. For example, the additive may include a negative electrode film-forming additive and a positive electrode film-forming additive, and may further include an additive that can improve certain performances of the battery, such as an additive that improves the overcharge performance of the battery, or an additive that improves the high temperature or low-temperature performance of the battery.

[Separator]

In some embodiments, the secondary battery further comprises a separator. The type of the separator is not particularly limited in the present application, and any well-known porous-structure separator with good chemical stability and mechanical stability may be selected.

In some embodiments, the material of the separator may be selected from at least one of glass fibers, nonwoven fabrics, polyethylene, polypropylene and polyvinylidene fluoride. The separator may be either a single-layer film or a multi-layer composite film, and is not limited particularly. When the separator is a multi-layer composite film, the materials in the respective layers may be same or different, which is not limited particularly.

In some embodiments, an electrode assembly may be formed by a positive electrode plate, a negative electrode plate and a separator by a winding process or a stacking process.

In some embodiments, the secondary battery may comprise an outer package. The outer package may be used to encapsulate the above-mentioned electrode assembly and electrolyte.

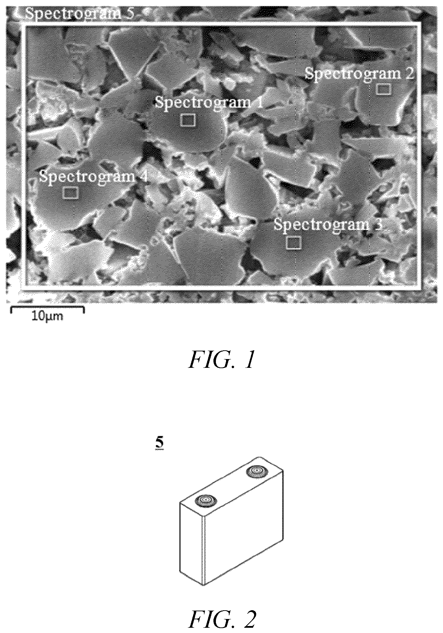

In some embodiments, the outer package of the secondary battery can be a hard housing, for example, a hard plastic housing, an aluminum housing, a steel housing, etc. The outer package of the secondary battery may also be a soft bag, such as a pouch-type soft bag. The material of the soft bag may be plastics, and the examples of plastics may comprise polypropylene, polybutylene terephthalate, polybutylene succinate, etc. The shape of the secondary battery is not particularly limited in the present application and may be cylindrical, square or of any other shape. For example, Fig. 2 shows a secondary battery 5 with a square structure as an example.

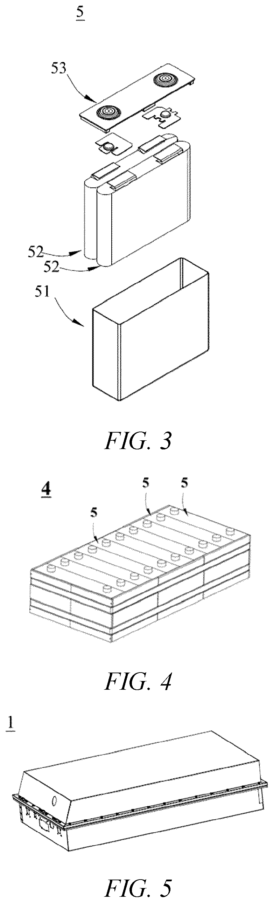

In some embodiments, with reference to Fig. 3, the outer package may include a housing 51 and a cover plate 53. Herein, the housing 51 may comprise a bottom plate and side plates connected to the bottom plate, and the bottom plate and the side plates enclose to form an accommodating cavity. The housing 51 has an opening in communication with the accommodating cavity, and the cover plate 53 may cover the opening to close the accommodating cavity. The positive electrode plate, the negative electrode plate, and the separator may be subjected to a winding process or a laminating process to form an electrode assembly 52. The electrode assembly 52 is encapsulated in the accommodating cavity. The electrolyte solution infiltrates the electrode assembly 52. The number of the electrode assemblies 52 contained in the secondary battery 5 may be one or more, and can be selected by those skilled in the art according to actual requirements.

In some embodiments, the secondary battery can be assembled into a battery module, and the number of the secondary batteries contained in the battery module may be one or more, and the specific number can be selected by those skilled in the art according to the application and capacity of the battery module.

FIG. 4 shows a battery module 4 as an example. Referring to FIG. 4, in the battery module 4, a plurality of secondary batteries 5 may be arranged in sequence in a length direction of the battery module 4. Apparently, the secondary batteries may also be arranged in any other manner. Furthermore, the plurality of secondary batteries 5 may be fixed by fasteners.

Optionally, the battery module 4 may further comprise an outer housing with an accommodating space, and the plurality of secondary batteries 5 are accommodated in the accommodating space.

In some embodiments, the above battery module may also be assembled into a battery pack, the number of the battery modules contained in the battery pack may be one or more, and the specific number can be selected by those skilled in the art according to the application and capacity of the battery pack.

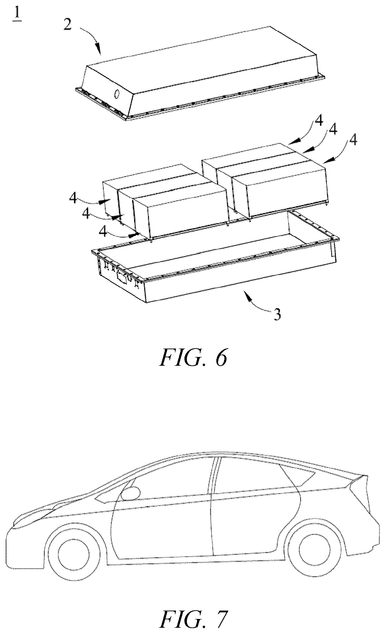

Fig. 5 and Fig. 6 show a battery pack 1 as an example. With reference to Fig. 5 and Fig. 6, the battery pack 1 may comprise a battery box and a plurality of battery modules 4 provided in the battery box. The battery box comprises an upper box body 2 and a lower box body 3, wherein the upper box body 2 may cover the lower box body 3 to form a closed space for accommodating the battery modules 4. A plurality of battery modules 4 may be arranged in the battery case in any manner.

In addition, the present application further provides a power consuming device. The power consuming device comprises at least one of the secondary battery, the battery module, or the battery pack provided by the present application. The secondary battery, battery module or battery pack can be used as a power source of the power consuming device or as an energy storage unit of the power consuming device. The power consuming device may include a mobile device (e.g., a mobile phone, a laptop computer, etc.), an electric vehicle (e.g., a pure electric vehicle, a hybrid electric vehicle, a plug-in hybrid electric vehicle, an electric bicycle, an electric scooter, an electric golf cart, an electric truck, etc.), an electric train, ship, and satellite, an energy storage system, etc., but is not limited thereto.

As for the power consuming device, the secondary battery, battery module or battery pack can be selected according to the usage requirements thereof.

Fig. 7 shows a power consuming device as an example. The power consuming device may be a pure electric vehicle, a hybrid electric vehicle, a plug-in hybrid electric vehicle, etc. In order to meet the requirements of the power consuming device for a high power and a high energy density of a secondary battery, a battery pack or a battery module may be used.

As another example, the device may be a mobile phone, a tablet computer, a laptop computer, etc. The device is generally required to be thin and light, and may have a secondary battery used as a power source.

## Examples

Hereinafter, the examples of the present application will be explained. The examples described below are exemplary and are merely for explaining the present application, and should not be construed as limiting the present application. The examples in which techniques or conditions are not specified are based on the techniques or conditions described in documents in the art or according to the product introduction. The reagents or instruments used therein for which manufacturers are not specified are all conventional products that are commercially available.

### Example 1

1. Preparation of silicon-carbon composite material

A porous carbon skeleton (with a total pore volume of 1.1 $cm^3/g$, 0.17 $cm^3/g$ of macropores, 0.65 $cm^3/g$ of mesopores, and 0.28 $cm^3/g$ of micropores) with a specific surface area of 1440 $m^2/g$ and an oil absorption number of 160 mL/100 g was provided. The porous carbon skeleton was heated to 600°C and a silane gas was introduced at 4 L/min for vapor deposition for 10 h to obtain an intermediate material with silane deposited; and then with the temperature being maintained at 600°C, a $CO_2$ gas was introduced and the temperature changes of the system were monitored, during which it was monitored that the temperature increased to about 605°C first and then decreased, and when the temperature decreased below 605°C, the introduce of the $CO_2$ gas was stopped, thus achieving the surface micro-oxidization of the intermediate material. At last, at 950°C, an acetylene gas was introduced at 2 L/min for vapor deposition for 2 h to obtain a 5% carbon coating layer. Finally, the silicon-carbon composite material of the present application was obtained.

2. Preparation of negative electrode plate

Using water as a solvent, the silicon-carbon composite material prepared as above, graphite, a binder of a styrene butadiene rubber (SBR), an adhesive of an acrylic acid-acrylonitrile-acrylamide copolymer, a conductive agent of Super P, a conductive agent of carbon nanotubes, and sodium carboxymethyl cellulose were mixed at a mass ratio of 20 : 80 : 0.8 : 1 : 1 : 1 : 0.5 to prepare a negative electrode slurry (with a solid content of about 55%). The above negative electrode slurry was evenly coated onto a current collector of a copper foil (with a load of 7.2 mg/cm$^2$), followed by drying, cold pressing and slitting to obtain a negative electrode plate.

3. Preparation of positive electrode plate

Using methylpyrrolidone (NMP) as a solvent, lithium nickel manganese cobalt oxide of NCM811, conductive carbon of SP, and a binder of polyvinylidene fluoride (PVDF) were mixed at a mass ratio of 97 : 1.5 : 1.5 to prepare a positive electrode slurry (with a solid content of 76%). The above positive electrode slurry was evenly coated onto a current collector of an aluminum foil (with a load of 18.7 mg/cm$^2$), followed by drying, cold pressing and slitting to obtain a positive electrode plate.

4. Preparation of the battery

LiPF$_6$ was added into a mixed solution of ethylene carbonate (EC)/diethyl carbonate (DEC) (with a volume ratio of 1 : 1 at room temperature) to obtain a solution with a concentration of 1 M as an electrolyte. Using polyethylene (PE) as a separator, in a low-humidity and constant temperature room, the positive electrode plate and the negative electrode plate prepared as above were stacked and wound in an order of "positive electrode plate-separator-negative electrode plate", and then placed into a housing and filled with the electrolyte to assemble same into a lithium-ion secondary battery.

5. Test for oil absorption number

[0128] With reference to the method described in the national standard GB/T 3780.2-2007, an instrument method A described therein was used, and the test was carried out using a sample in an amount of 20 g and dibutyl phthalate (DBP) as a reagent.

6. X-ray energy dispersive spectrum (EDS) test

The electrode plate to be tested was cut into a sample with a size of 6 mm × 6 mm, placed on an ion polishing (CP) sample table (allowing the sample to stick out of the sample table within 1 mm), and cut at a voltage of 7.5 KV for about 30 min (the time can be appropriately adjusted according to the material and thickness of the sample) to obtained an ion-polished sample.

With reference to the method disclosed in GB/T 17359-2012, the silicon content at the central area of the silicon-carbon composite material particles was measured: a field emission scanning electron microscope (Zeiss Sigma300) was used to test the ion-polished electrode plate sample. Four cross-sections of the silicon-carbon composite material particle having a long axis length equal to the Dv50 of the material were randomly selected within the field of view of the electron microscope, and then the silicon content at the midpoint of the long axis on each cross-section was measured by means of EDS to calculate an average value.

Fig. 1 shows an ion-polished cross-sectional topographic analysis image of an electrode plate sample. As shown in Fig. 1, four particle cross-sections having a long axis equal to the Dv50 were respectively selected, and the silicon content at the center of the particles was respectively tested at the midpoint of the long axis on the selected cross-sections (the test points corresponded to the spectrograms 1-4 marked in Fig. 1, respectively).

7. Inductively coupled plasma (ICP) emission spectroscopy test - overall silicon content of silicon-carbon composite material

A material sample was charged into a digestion tank and a mixed acid of concentrated nitric acid/hydrofluoric acid was added, and the tank was placed into a microwave digestion instrument for sample digestion. The content of silicon element of the digested sample solution was measured in an inductively coupled plasma emission spectrometer.

8. Test for capacity per gram of material

A single-sided negative electrode plate was coated using the above method, punched into a small disc having a diameter of 14 mm, and assembled into a button cell with a separator and a lithium plate. As calculated on the basis of 1 C = 600 mAh/g, the capacity per gram was tested by the following method:
the above button cell was discharged to 5 mV at a rate of 0.05 C, then discharged to 5 mV at 50 μA, and then discharged to 5 mV at 10 μA. The above cell was allowed to stand for 5 min, and then charged to 2 V at 0.1 C. The capacity of the cell was tested at this moment. The ratio of the capacity to the weight of the active substance in the electrode plate was calculated, so as to obtain the capacity per gram of the active substance material.

9. Test for cycle life

At an ambient temperature of 25°C, first, a battery was discharged at a constant current rate of 0.33 C to 2.7 V, allowed to stand for 5 min, then charged at a constant current rate of 0.5 C to 4.2 V, then charged at a constant voltage of 4.2 V to 0.05 C, allowed to stand for 5 minutes, and then discharged at a constant current rate of 0.33 C to 2.7 V. Such a process was regarded as a first cycle, and the capacity of the battery at this moment was measured as C1. The above steps were repeated until the capacity decayed to 80% of C1, and the number of cycles at this moment was the cycle life.

10. Test for volume-average particle size (Dv50)

An appropriate amount of a sample to be tested was added into a clean beaker, a surfactant was added dropwise, and then a dispersant was added, followed by an untrasonic treatment at 120 W/5 min to ensure the full dispersion of the sample in the dispersant. The particle size distribution characteristic of the sample was tested by using a Malvern 3000 laser particle size analyzer to obtain Dv50.

Example 2

The preparation and test methods of example 1 were used. The difference was a porous carbon skeleton having a specific surface area of 750 m$^2$/g, an oil absorption number of 155 mL/100 g, a total pore volume of 1.02 cm$^3$/g, 0.16 cm$^3$/g of macropores, 0.6 cm$^3$/g of mesopores, and 0.26 cm$^3$/g of micropores.

**Example 3**

The preparation and test methods of example 1 were used. The difference was a porous carbon skeleton having a specific surface area of 1100 m$^2$/g, an oil absorption number of 158 mL/100 g, a total pore volume of 1.15 cm$^3$/g, 0.18 cm$^3$/g of macropores, 0.68 cm$^3$/g of mesopores, and 0.29 cm$^3$/g of micropores.

**Example 4**

The same porous carbon skeleton, preparation method and test methods as example 2 were used. The differences were that after a silicane deposited intermediate material was obtained, 8 wt%, based on the total weight of the intermediate material, of asphalt having a softening point of 160°C softening point was added and mixed until uniform, and then carbonized under a nitrogen atmosphere to obtain a silicon-carbon composite material having a 5% carbon coating.

**Examples 5-10**

The preparation and test methods of example 1 were used. The difference was that the carbon skeletons in examples 5-10 had a different oil absorption number (see Table 2 for detail), thus obtaining the silicon-carbon composite materials with a different oil absorption number. The relevant parameters of the carbon skeletons in the above examples are listed in Table 1 below:

Table 1

| | Specific surface area m²/g | Total pore volume cm³/g | Macropore volume cm³/g | Mesopore volume cm³/g | Micropore volume cm³/g |
|---|---|---|---|---|---|
| Example 5 | 703 | 1.09 | 0.18 | 0.66 | 0.25 |
| Example 6 | 739 | 1.11 | 0.18 | 0.68 | 0.25 |
| Example 7 | 856 | 1.15 | 0.19 | 0.69 | 0.27 |
| Example 8 | 975 | 1.18 | 0.19 | 0.70 | 0.29 |
| Example 9 | 623 | 1.02 | 0.15 | 0.65 | 0.22 |
| Example 10 | 684 | 1.05 | 0.17 | 0.65 | 0.23 |

**Comparative examples 1-2**

The preparation and test methods of example 1 were used. The differences were that in comparative example 1, 18 wt% of asphalt was used for coating and carbonization to obtain a silicon-carbon composite material with a carbon coating of about 10.8% and a small oil absorption number; and in comparative example 2, 5 wt% of asphalt was used for coating and a skeleton having a too large oil absorption number was used, and thus a silicon-carbon composite material with a carbon coating of about 3% and a large oil absorption number was obtained.

**Comparative example 3**

The preparation and test methods of example 1 were used. The difference was a porous carbon skeleton having a specific surface area of 20 m²/g, an oil absorption number of 80 mL/100 g, a total pore volume of 0.22 cm³/g, 0.07 cm³/g of macropores, 0.09 cm³/g of mesopores, and 0.06 cm³/g of micropores.

**Comparative example 4**

The porous carbon skeleton, preparation method and test methods as example 1 were used. The difference was that a silicon-carbon composite material without a carbon coating was obtained.

**Comparative example 5**

The same porous carbon skeleton, preparation method and test methods as example 1 were used. The differences were that after a silicane deposited intermediate material was obtained, a $CO_2$ gas was introduced to micro-oxidize the material; and at last, 2 wt%, based on the total weight of the intermediate material, of asphalt having a softening point of 250°C was added and mixed until uniform, followed by carbonization to form a coating under a nitrogen atmosphere to obtain a silicon-carbon composite material having a 1.2% carbon coating.

**Comparative example 6**

A 60 nm nano-silicon powder and an emulsified asphalt were mixed until uniform and atomized at 180°C to prepare 10 um cured particles; and the particles were placed in asphalt having a softening point of 90°C, impregnated with asphalt to be densified, and then carbonized at 1150°C to prepare a nano-silicon particle wrapped silicon-carbon composite material having a diameter of 10 um.

The of the above examples and comparative examples are shown in Table 2.

Table 2

| | Oil absorption number of carbon skeleton (mL/100 g) | Oil absorption number of silicon-carbon composite material (mL/100 g) | Overall ICP silicon content of material | Silicon content at the center of material particle* | k** | Gram capacity of material (mAh/g) | Number of cycles for capacity decaying to 80% |
|---|---|---|---|---|---|---|---|
| Comparative example 1 | 125 | 33 | 34.4% | 22.1% | 102.0 | 1390 | 1521 |
| Example 1 | 160 | 62 | 37.7% | 27.9% | 136.9 | 1550 | 1583 |
| Example 2 | 155 | 55 | 36.9% | 26.3% | 152.7 | 1550 | 1592 |
| Example 3 | 158 | 53 | 37.0% | 25.6% | 161.1 | 1540 | 1596 |
| Example 4 | 160 | 48 | 37.8% | 26.2% | 176.4 | 1520 | 1597 |
| Example 5 | 137 | 35 | 36.2% | 24.6% | 216.3 | 1420 | 1548 |
| Example 6 | 143 | 45 | 36.5% | 24.2% | 174.1 | 1450 | 1569 |
| Example 7 | 175 | 70 | 39.4% | 26.5% | 126.9 | 1580 | 1548 |
| Example 8 | 189 | 80 | 39.7% | 27.3% | 119.0 | 1590 | 1507 |
| Comparative example 2 | 210 | 85 | 41.7% | 31.4% | 197.5 | 1630 | 1390 |
| Example 9 | 100 | 49 | 35.3% | 21.4% | 115.6 | 1504 | 1509 |
| Example 10 | 120 | 50 | 35.6% | 21.0% | 134.8 | 1508 | 1517 |
| Comparative example 3 | 80 | 55 | 39.1% | 13.1% | 74.4 | 1400 | 989 |
| Comparative example 4 | 160 | 100 | 38.5% | 25.4% | - | 1440 | 1036 |
| Comparative example 5 | 160 | 110 | 38.2% | 25.7% | 317.3 | 1440 | 1158 |
| Comparative example 6 | - | 30 | 38.1% | 33.7% | - | 1520 | 983 |

* The silicon content at the center of the particle is obtained by the following methods: among the cross-sections of the particles that are obtained by subjecting the material to ion polishing, selecting a cross-section with a long axis length equal to the volume-average particle size of the particles, and determining the silicon content at the midpoint of the long axis on the selected cross-section. Four cross-sections are taken to determine the silicon content at the center of the particles, and the average value is calculated. The values shown in the Table are average values. In the above Table, all silicon-carbon composite materials have a particle size of about 10 $\mu$m.

** $k = \dfrac{X1}{Y1 \times Y2 \times X2}$, where X1 is the oil absorption number of the porous carbon skeleton, X2 is the oil absorption number of the silicon-carbon composite material, Y1 is the total weight percentage of silicon in the silicon-carbon composite material, and Y2 is the weight percentage of the carbon coating layer.

It also can be seen from Table 2 that in the silicon-carbon composite material of the present application, the porous carbon skeleton has a large oil absorption number, but the final composite material has a small oil absorption number; and moreover, the particles of the silicon-carbon composite material of the present application have a uniform silicon distribution and in particular a high silicon content at the central area, and therefore have good overall performance- - a higher capacity per gram and a longer cycle life.

Examples 11-14

According to example 1, the porous carbon skeleton shown in Table 3 and the silicon-carbon composite material prepared therefrom were used, and the performance thereof were tested. The effect of the overall silicon content of the material on the performance thereof is shown in Table 3.

Table 3

| | Oil absorption number of carbon skeleton (mL/100 g) | Oil absorption number of silicon-carbon composite material (mL/100 g) | Overall ICP silicon content of material | Silicon content at the center of material particle | k | Gram capacity of material (mAh/g) | Number of cycles for capacity decaying to 80% |
|---|---|---|---|---|---|---|---|
| Example 11 | 121 | 45 | 21.4% | 14.1% | 251.3 | 1040 | 986 |
| Example 12 | 136 | 52 | 33.5% | 18.3% | 156.1 | 1310 | 1108 |
| Example 13 | 179 | 69 | 45.8% | 33.2% | 113.3 | 1710 | 1254 |
| Example 14 | 193 | 73 | 52.3% | 35.7% | 101.1 | 1840 | 1037 |
| Comparative example 7 | 210 | 81 | 64.2% | 46.6% | 80.8 | 2105 | 923 |

It can be seen from Table 3 that when the total silicon content of the silicon-carbon composite material is 20-60 wt%, the amount of the silicon-carbon composite material required for compounding with graphite is moderate, which consequently reduces the side reactions and improves the cycling performance.
The silicon content at the central area of the silicon-carbon composite material particles falls within the ranges in the present application and carbon skeleton can constrain the expansion of silicon, which is beneficial for improving the cycling performance.

**Examples 15-19**

The silicon-carbon composite materials were prepared using a preparation method similar to that of example 1, wherein the silicon-carbon composite materials with different carbon coating amounts were obtained by controlling the vapor deposition time of the acetylene gas in the third step. The effect of different carbon coating amounts on the performance is shown in Table 4.

Table 4

| | Carbon coating amount (wt.%) | Oil absorption number of silicon-carbon composite material (mL/100 g) | Gram capacity of material (mAh/g) | Number of cycles for capacity decaying to 80% |
|---|---|---|---|---|
| Example 15 | 3 | 79 | 1579 | 1028 |
| Example 16 | 3.5 | 71 | 1573 | 1302 |
| Example 17 | 5 | 62 | 1550 | 1583 |
| Example 18 | 7 | 44 | 1496 | 1379 |
| Example 19 | 10 | 39 | 1473 | 1296 |

It can be seen from Table 4 that when the silicon-carbon composite material of the present application has a carbon coating amount described above, it has a good energy density and cycle life.

In addition, Table 5 shows the test results (including randomly taking four cross-sections with a long axis length equal to Dv50 of the particles, respectively determining the silicon content (wt%) at the center of the particles, and calculating the average value) of the overall silicon content and the silicon content at the central area of the silicon-carbon composite material particles of example 1 (with reference to Fig. 1), comparative example 3 and comparative example 6 of the present application.

Table 5

| | | Example 1 | Comparative example 3 | Comparative example 6 |
|---|---|---|---|---|
| Overall silicon content (wt%) | | 38 | 39 | 38 |
| Silicon content at the center of particle (wt%) | 1 | 25.8 | 12.3 | 35.2 |
| | 2 | 29.6 | 11.9 | 32.1 |
| | 3 | 27.3 | 13.6 | 37.4 |
| | 4 | 28.9 | 14.7 | 30.1 |
| | Average value | 27.9 | 13.1 | 33.7 |

It can be seen from Table 5 that the silicon-carbon composite material in example 1 of the present application has a high silicon content at the center of the particles, and the distribution of the silicon contents at the center of the particles of different particles is more uniform. The material of comparative example 3 has a low silicon content at the center of the particles, which indicates that when the overall silicon content thereof is comparable to that of the material in example 1, the silicon deposition layer is more distributed in the superficial part of the material particles, and the capacity per gram and the cycle life thereof are both poor, see Table 2. The material of comparative example 6 has a high silicon content at the center of the particles but does not have a carbon coating layer, and therefore it has a poor cycle life, see Table 2.

It should be noted that the present application is not limited to the above embodiments. The above embodiments are exemplary only, and any embodiment that has substantially the same constitutions as the technical ideas and has the same effects within the scope of the technical solution of the present application falls within the technical scope of the present application. In addition, without departing from the gist of the present application, various modifications that may be conceived by those skilled in the art to the embodiments, and other modes constructed by combining some of the constituent elements of the embodiments also fall within the scope of the present application.

**Claims**

1. A silicon-carbon composite material, in the form of particles comprising a porous carbon skeleton, a silicon-containing deposition layer, and a carbon-containing coating layer, wherein the silicon-containing deposition layer is in pores of the porous carbon skeleton, the carbon-containing coating layer is on the silicon-containing deposition layer and/or on the surface of the particles, and the silicon-carbon composite material has an oil absorption number of 35 mL/100 g to 80 mL/100 g.

2. The silicon-carbon composite material according to claim 1, wherein the silicon-carbon composite material has an oil absorption number of 45 mL/100 g to 70 mL/100 g, optionally 48 mL/100 g to 62 mL/100 g.

3. The silicon-carbon composite material according to claim 1 or 2, wherein the silicon content at the center of the particles of the silicon-carbon composite material is $\geq$ 10 wt%, optionally $\geq$ 15 wt%, more optionally 20 wt% to 35 wt%, based on the total weight of the particle; wherein the silicon content at the center of the particles is obtained by the following methods: among the cross-sections of the particles that are obtained by subjecting the material to ion polishing, selecting a cross-section with a long axis length equal to the volume-average particle size of the particles, and determining the silicon content at the midpoint of the long axis on the selected cross-section.

4. The silicon-carbon composite material according to any one of claims 1-3, wherein the porous carbon skeleton has a connected-pore structure and an oil absorption number of $\geq$ 100 mL/100 g, optionally $\geq$ 120 mL/100 g, more optionally $\geq$ 150 mL/100 g and $\leq$ 190 mL/100 g; and optionally, the porous carbon skeleton has an oil absorption number of 136 mL/100 g to 179 mL/100 g.

5. The silicon-carbon composite material according to any one of claims 1-4, wherein the silicon-carbon composite material comprises 20 wt% to 60 wt%, optionally 30 wt% to 50 wt%, more optionally 35 wt% to 45 wt% of silicon, based on the total weight of the silicon-carbon composite material.

6. The silicon-carbon composite material according to any one of claims 1-5, wherein the carbon-containing coating layer accounts for 3 wt% to 10 wt%, optionally 3.5 wt% to 7 wt%, more optionally 4 wt% to 6 wt%, based on the total weight of the silicon-carbon composite material.

7. The silicon-carbon composite material according to claims 1-6, wherein the oil absorption number X1 of the porous carbon skeleton, the oil absorption number X2 of the silicon-carbon composite material, the weight percentage Y1 of silicon in the silicon-carbon composite material, and the weight percentage Y2 of the carbon coating layer satisfy:

$$k = \frac{X1}{Y1 \times Y2 \times X2},$$

and
k is any value of 100 to 250, optionally 130 to 180.

8. A silicon-carbon composite material, prepared by the steps of:

i) providing a porous carbon skeleton, wherein the porous carbon skeleton has a connected-pore structure and has an oil absorption number of $\geq$ 100 mL/100 g and $\leq$ 190 mL/100 g;
ii) forming a silicon-containing deposition layer in pores of the porous carbon skeleton by means of chemical vapor deposition using a silicon-containing gas source to obtain an intermediate material; and
iii) forming a carbon-containing coating layer on the silicon-containing deposition layer of the intermediate material and/or on the surface of the particles of the porous carbon skeleton to obtain the granular silicon-carbon composite material, wherein the carbon-containing coating layer accounts for 3 wt% to 10 wt%, based on the total weight of the silicon-carbon composite material; and

wherein the silicon-carbon composite material has an oil absorption number of 35 mL/100 g to 80 mL/100 g.

9. The silicon-carbon composite material according to claim 8, wherein the silicon-carbon composite material has an oil absorption number of 45 mL/100 g to 70 mL/100 g, optionally 48 mL/100 g to 62 mL/100 g.

10. The silicon-carbon composite material according to claim 8 or 9, wherein the silicon content at the center of the particles of the silicon-carbon composite material is $\geq$ 10 wt%, optionally $\geq$ 15 wt%, more optionally 20 wt% to 35 wt%, based on the total weight of the particle; wherein the silicon content at the center of the particles is obtained by the following methods: among the cross-sections of the particles that are obtained by subjecting the material to ion polishing, selecting a cross-section with a long axis length equal to the volume-average particle size of the particles, and determining the silicon content at the midpoint of the long axis on the selected cross-section.

11. The silicon-carbon composite material according to any one of claims 8-10, wherein the porous carbon skeleton has an oil absorption number of $\geq$ 120 mL/100 g, optionally $\geq$ 150 mL/100 g; and optionally, the porous carbon skeleton has an oil absorption number of 136 mL/100 g to 179 mL/100 g.

12. The silicon-carbon composite material according to any one of claims 8-11, wherein the silicon-carbon composite material comprises 20 wt% to 60 wt%, optionally 30 wt% to 50 wt%, more optionally 35 wt% to 45 wt% of silicon, based on the total weight of the silicon-carbon composite material.

13. The silicon-carbon composite material according to any one of claims 8-12, wherein the carbon-containing coating layer accounts for 3.5 wt% to 7 wt%, optionally 4 wt% to 6 wt%, based on the total weight of the silicon-carbon composite material.

14. The silicon-carbon composite material according to claims 8-13, wherein the oil absorption number X1 of the porous carbon skeleton, the oil absorption number X2 of the silicon-carbon composite material, the weight percentage Y1 of silicon in the silicon-carbon composite material, and the weight percentage Y2 of the carbon coating layer satisfy the following relationship:

$$k = \frac{X1}{Y1 \times Y2 \times X2},$$

and

k is any value of 100 to 250, optionally 130 to 180.

15. A negative electrode plate, comprising a current collector and a negative electrode material layer provided on at least one surface of the current collector, wherein the negative electrode material layer comprises a silicon-carbon composite material according to any one of claims 1-14.

16. The negative electrode plate according to claim 15, wherein the negative electrode material layer comprises 5 wt% to 50 wt%, optionally 10 wt% to 30 wt%, more optionally 15 wt% to 25 wt% of the silicon-carbon composite material, based on the total weight of the negative electrode material layer.

17. A secondary battery, comprising a silicon-carbon composite material according to any one of claims 1-14, or a negative electrode plate according to any one of claims 15 to 17.

18. A battery module, comprising a secondary battery according to claim 17.

19. A battery pack, comprising a battery module according to claim 18.

20. A power consuming device, comprising at least one selected from a secondary battery according to claim 17, a battery module according to claim 18, or a battery pack according to claim 19.

*FIG. 1*

5

*FIG. 2*

5

53

52
52

51

FIG. 3

4    5    5

5

FIG. 4

1

FIG. 5

*FIG. 6*

*FIG. 7*

## INTERNATIONAL SEARCH REPORT

| International application No. |
| --- |
| **PCT/CN2022/105168** |

| A. | CLASSIFICATION OF SUBJECT MATTER |
| --- | --- |

H01M4/38(2006.01)i;H01M4/62(2006.01)i

According to International Patent Classification (IPC) or to both national classification and IPC

| B. | FIELDS SEARCHED |
| --- | --- |

Minimum documentation searched (classification system followed by classification symbols)

IPC:H01M

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 负极, 阳极, 硅, 碳, 多孔, 骨架, 包覆, 沉积, 吸油, negative, electrode, anode, silicon, Si, carbon, porous, framework, coat+, deposit+, oil absorption

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | CN 113078318 A (GUANGDONG KAIJIN NEW ENERGY TECHNOLOGY CO., LTD.) 06 July 2021 (2021-07-06)<br>description, paragraphs 2 and 6-70 | 1-20 |
| Y | CN 105765772 A (MITSUBISHI CHEMICAL CORP.) 13 July 2016 (2016-07-13)<br>description, paragraphs 42-90 | 1-20 |
| Y | CN 107820645 A (TEC ONE CO., LTD.) 20 March 2018 (2018-03-20)<br>description, paragraphs 9-34 | 1-20 |
| Y | CN 114122352 A (XI'AN JIAOTONG UNIVERSITY) 01 March 2022 (2022-03-01)<br>description, paragraphs 6-81 | 1-20 |
| A | CN 114122370 A (XI'AN JIAOTONG UNIVERSITY) 01 March 2022 (2022-03-01)<br>entire document | 1-20 |
| A | JP 2016154114 A (OSAKA GAS CO., LTD.) 25 August 2016 (2016-08-25)<br>entire document | 1-20 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **27 March 2023** | **06 April 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**INTERNATIONAL SEARCH REPORT**
Information on patent family members

International application No.

**PCT/CN2022/105168**

| Patent document cited in search report | | | Publication date (day/month/year) | Patent family member(s) | | | Publication date (day/month/year) |
|---|---|---|---|---|---|---|---|
| CN | 113078318 | A | 06 July 2021 | None | | | |
| CN | 105765772 | A | 13 July 2016 | KR | 20160090338 | A | 29 July 2016 |
| | | | | US | 2016276668 | A1 | 22 September 2016 |
| | | | | US | 11450853 | B2 | 20 September 2022 |
| | | | | WO | 2015080203 | A1 | 04 June 2015 |
| | | | | JPWO | 2015080203 | A1 | 16 March 2017 |
| | | | | JP | 6432519 | B2 | 05 December 2018 |
| | | | | US | 2022407070 | A1 | 22 December 2022 |
| | | | | EP | 3076461 | A1 | 05 October 2016 |
| | | | | EP | 3076461 | A4 | 07 December 2016 |
| | | | | EP | 3076461 | B1 | 27 June 2018 |
| | | | | KR | 20220020407 | A | 18 February 2022 |
| | | | | KR | 102469839 | B1 | 22 November 2022 |
| CN | 107820645 | A | 20 March 2018 | US | 2018316002 | A1 | 01 November 2018 |
| | | | | KR | 101865633 | B1 | 08 June 2018 |
| | | | | DE | 112017000040 | T5 | 21 February 2019 |
| | | | | JP | 6229245 | B1 | 15 November 2017 |
| | | | | JPWO | 2018198282 | A1 | 27 June 2019 |
| | | | | WO | 2018198282 | A1 | 01 November 2018 |
| CN | 114122352 | A | 01 March 2022 | None | | | |
| CN | 114122370 | A | 01 March 2022 | None | | | |
| JP | 2016154114 | A | 25 August 2016 | JP | 6505464 | B2 | 24 April 2019 |

Form PCT/ISA/210 (patent family annex) (July 2022)